# EUROPEAN PATENT APPLICATION

(11) **EP 4 618 718 A1**
(43) Date of publication of application: **17.09.2025**
(21) Application number: 25163953.0
(22) Date of filing: 14.03.2025
(51) Int. Cl.: H10D 30/69, H10D 30/67, H10D 62/80

(54) **OXIDE SEMICONDUCTOR MEMORY DEVICE AND MANUFACTURING METHOD THEREOF**

(30) Priority: 15.03.2024 KR 20240036401; 03.09.2024 KR 20240118975
(71) Applicant: Korea Advanced Institute of Science and Technology, Daejeon 34141 (KR)
(72) Inventor: CHO, Byung Jin, 34141 Daejeon (KR); PARK, YoungKeun, 34141 Daejeon (KR); KIM, Heetae, 34141 Daejeon (KR); JEONG, Jaejoong, 34141 Daejeon (KR)
(74) Representative: Mathys & Squire

(57) **Abstract**

The present disclosure relates to an oxide semiconductor memory device and a manufacturing method thereof, and more particularly, to an oxide semiconductor memory device forming an amorphous indium-gallium-zinc-oxide (hereinafter, referred to as a-IGZO) thin film and a manufacturing method thereof. The present disclosure is to solve a problem of oxide semiconductor forming an a-IGZO thin film having a negative threshold voltage and improve mobility characteristics.

## Description

### CROSS-REFERENCE TO RELATED APPLICATIONS

This application claims priority under 35 U.S.C. §119 to Korean Patent Application No. 10-2024-0036401, filed on March 15th, 2024, and No. 10-2024-0118975, filed on September 3rd, 2024, in the Korean Intellectual Property Office, the disclosure of which is incorporated herein by reference in its entirety.

### TECHNICAL FIELD

The following disclosure relates to an oxide semiconductor memory device and a manufacturing method thereof, and more particularly, to an oxide semiconductor memory device forming an amorphous indium-gallium-zinc-oxide (hereinafter, referred to as a-IGZO) thin film and a manufacturing method thereof.

### BACKGROUND

Currently, the demand for memory semiconductors is increasing explosively due to the 4th industrial revolution. As Internet-on-Things (IoT) devices are increasing explosively, the demand for memory is increasing in an edge device including a smartphone, and the amount of data that should be handled is increasing explosively as deep learning is utilized.

In order to keep up with this technological trend, nonvolatile memory semiconductors require high integration and excellent memory performance, and 3D NAND flash memory is leading the nonvolatile memory market because it is far superior to other methods in terms of device integration.

The 3D NAND flash memory is not only playing the role of nonvolatile memory, but is also attracting attention as a computing-in-memory (CIM) device for the upcoming AI era. The CIM device is a device that performs a multiply and accumulation (MAC) operation, a core operation of deep learning, at the memory level, and may operate more efficiently because frequent data transfer between logic and memory is reduced.

In the latest trend of the devices that cause the memory to perform the operation, it is more essential than ever to perform memory read, write, and erase operations on the memory as quickly as possible and store a large amount of information (e.g., 3 bits/cell) in a single device.

Meanwhile, research on oxide semiconductors to replace silicon-based semiconductor devices is being widely conducted to improve the performance of the 3D NAND flash memory. In terms of materials, research results on single, binary, and ternary compounds based on indium oxide (In₂O₃), zinc oxide (ZnO), gallium oxide (Ga₂O₃), indium zinc oxide (InZnO), zinc tin oxide (ZTO), and indium gallium zinc oxide (InGaZnO) are being reported. The oxide semiconductors have the advantage of superior mobility compared to hydrogenated amorphous silicon.

However, the oxide semiconductors have the problem of low stability from external stress along with the characteristic of operating normally-on because the oxide semiconductors have a negative threshold voltage.

### SUMMARY

An embodiment of the present disclosure is directed to solving a problem of oxide semiconductor forming an a-IGZO thin film having a negative threshold voltage and improving mobility characteristics.

In one general aspect, a method for manufacturing an oxide semiconductor memory device includes: (a) alternately laminating a word line and an inter layer dielectric; (b) forming a cylindrical hole in a center of the laminated word line and inter layer dielectric and forming a tunnel layer on an inner circumferential surface of the hole; (c) forming a charge trap layer on an inner circumferential surface of the tunnel layer; (d) forming a blocking layer on an inner circumferential surface of the charge trap layer; (e) forming an oxide channel on an inner circumferential surface of the blocking layer; and (f) forming a gate electrode by removing the inter layer dielectric and depositing a metal along the word line, in which, in (e), the oxide channel is formed of amorphous indium-gallium-zinc-oxide (a-IGZO) doped with fluorine.

(e) may include: (e-1) depositing an a-IGZO layer; (e-2) depositing a polymer layer containing a perfluorodecanoic acid (PFDA) on the a-IGZO layer; (e-3) depositing an aluminum oxide (Al₂O₃) layer on the polymer layer; and (e-4) performing a drive-in process of applying heat to the oxide channel.

In (e-2), the polymer layer containing the perfluorodecanoic acid may be deposited by an initiated chemical vapor deposition (iCVD) process.

In (e-3), the aluminum oxide layer may be deposited by an atomic layer deposition (ALD) process.

In (e-4), heat of 400°C may be applied.

In another general aspect, an oxide semiconductor memory device includes: a blocking layer that is located on an oxide channel; a charge trap layer that is located on the blocking layer and traps an injected charge; a tunnel layer that is located on the charge trap layer; and a gate electrode that is located on the tunnel layer and applied with an on voltage and an off voltage from a gate bias circuit, in which the oxide channel is formed of fluorine doped amorphous indium-gallium-zinc-oxide (a-IGZO).

The oxide channel may deposit a polymer layer containing a perfluorodecanoic acid (PFDA) by an initiated chemical vapor deposition (iCVD) process.

The oxide channel may deposit an aluminum oxide (Al₂O₃) layer by an atomic layer deposition (ALD) process.

### BRIEF DESCRIPTION OF THE DRAWINGS

FIG. 1 is a flowchart illustrating a method for manufacturing an oxide semiconductor memory device according to an exemplary embodiment of the present disclosure.
FIGS. 2A to 2F are cross-sectional views illustrating the method for manufacturing an oxide semiconductor memory device according to an exemplary embodiment of the present disclosure.
FIG. 3 is a flowchart illustrating a method for doping fluorine into an oxide channel of an oxide semiconductor memory device according to an exemplary embodiment of the present disclosure.
FIG. 4 is a graph illustrating the effect of the oxide semiconductor memory device according to an exemplary embodiment of the present disclosure.
FIG. 5 is a perspective cross-sectional view illustrating a configuration of the oxide semiconductor memory device according to an exemplary embodiment of the present disclosure.
FIG. 6 is a configuration diagram of the oxide semiconductor memory device according to an exemplary embodiment of the present disclosure.

### [Detailed Description of Main Elements]

- 50:: Oxide channel
- 100:: Blocking layer
- 200:: Charge trap layer
- 300:: Tunnel layer
- 400:: Gate electrode

### DETAILED DESCRIPTION OF EMBODIMENTS

The above-described objects, features, and advantages of the present disclosure will become more obvious from the following detailed description provided in relation to the accompanying drawings. The following specific structural or functional descriptions are only exemplified for the purpose of describing the embodiments according to the concept of the present disclosure, and the embodiments according to the concept of the present disclosure may be implemented in various forms and should not be construed as limited to the embodiments described herein or in the application. Since embodiments of the concept of the present disclosure may be variously modified and may have various forms, specific embodiments will be illustrated in the accompanying drawings and will be described in detail in the present specification or application. However, it is to be understood that the present disclosure is not limited to specific embodiments, but includes all modifications, equivalents, and substitutions falling in the spirit and the scope of the present disclosure. Terms such as 'first', 'second', or the like, may be used to describe various components, but these components are not to be construed as being limited to these terms. The terms are used only to distinguish one component from another component. For example, a first component may be named a second component and the second component may also be named the first component, without departing from the scope of the present disclosure. It is to be understood that when one component is referred to as being "connected to" or "coupled to" another component, it may be connected directly to or coupled directly to another component or be connected to or coupled to another component with the other component interposed therebetween. On the other hand, it is to be understood that when one component is referred to as being "connected directly to" or "coupled directly to" another component, it may be connected to or coupled to another component without the other component interposed therebetween. Other expressions for describing the relationship between components, such as between and immediately between or adjacent to and directly adjacent to, etc., should be interpreted similarly. Terms used in the present specification are used only in order to describe specific embodiments rather than limiting the present disclosure. Singular forms include plural forms unless the context clearly indicates otherwise. It is to be understood that terms "include," "have," or the like, used in the present specification specify the presence of features, numerals, steps, operations, components, parts, or a combination thereof described in the present specification, but do not preclude the presence or addition of one or more other features, numerals, steps, operations, components, parts, or a combination thereof. Unless indicated otherwise, it is to be understood that all the terms used in the specification including technical and scientific terms have the same meaning as those that are generally understood by those who skilled in the art. Terms generally used and defined in a dictionary are to be interpreted as the same meanings with meanings within the context of the related art, and are not to be interpreted as ideal or excessively formal meanings unless clearly indicated in the present specification. Hereinafter, exemplary embodiments of the present disclosure will be described in detail with reference to the accompanying drawings. The same reference numerals in each drawing denote the same components.

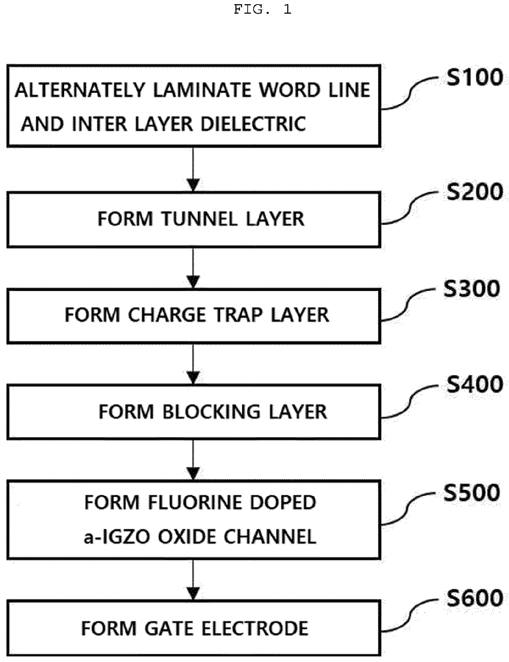

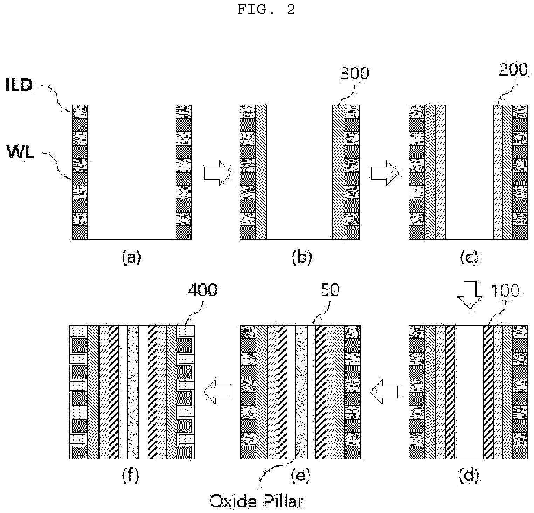

FIGS. 1 and 2A to 2F are flowcharts illustrating a method for manufacturing an oxide semiconductor memory device according to an exemplary embodiment of the present disclosure.

Referring to FIGS. 1 and 2A to 2F, a method for manufacturing an oxide semiconductor memory device according to an exemplary embodiment of the present disclosure may include alternately laminating a word line WL and an inter layer dielectric ILD (S100), forming a cylindrical hole in a center of the laminated word line WL and inter layer dielectric ILD and forming a tunnel layer 300 on an inner circumferential surface of the hole (S200), forming a charge trap layer 200 on an inner circumferential surface of the tunnel layer 300 (S300), forming a blocking layer 100 on an inner circumferential surface of the charge trap layer 200 (S400), forming an oxide channel 50 on an inner circumferential surface of the blocking layer 100 (S500), and forming a gate electrode 400 by removing the inter layer dielectric ILD and depositing a metal along the word line WL (S600) .

Here, steps S100 to S400 and S600 may follow a general 3D flash memory device process.

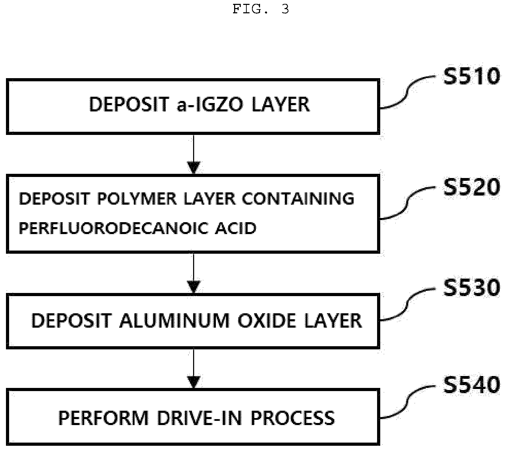

Meanwhile, S500 forms an amorphous indium-gallium-zinc-oxide (a-IGZO) oxide channel, and a process of doping fluorine into the a-IGZO may be added. Hereinafter, a method for doping fluorine into the a-IGZO oxide channel will be described in detail with reference to FIG. 3.

FIG. 3 is a flowchart illustrating a method for doping fluorine into an oxide channel of an oxide semiconductor memory device according to an exemplary embodiment of the present disclosure.

Referring to FIG. 3, the method for doping fluorine into an a-IGZO oxide channel of an oxide semiconductor memory device according to an exemplary embodiment of the present disclosure may include depositing an a-IGZO layer (S510), depositing a polymer layer containing a perfluorodecanoic acid (PFDA) on the a-IGZO layer (S520), depositing an aluminum oxide (Al₂O₃) layer on the polymer layer (S530), and performing a drive-in process for applying heat to the oxide channel (S540).

In the method for doping fluorine into an a-IGZO oxide channel of an oxide semiconductor memory device, in step, an a-IGZO layer may be deposited to form an oxide channel 50 based on a-IGZO.

In S520, the method for doping fluorine into an a-IGZO oxide channel of an oxide semiconductor memory device may deposit the polymer layer containing the perfluorodecanoic acid (PFDA) on the a-IGZO layer. The conventional method for doping fluorine into a-IGZO may cause ion collisions, which may cause problems of disruption of ionic bonds along with deterioration in morphology of the oxide channel. To solve this problem, the polymer layer containing the perfluorodecanoic acid (PFDA), which is a fluorine-based polymer containing fluorine, may be deposited on the a-IGZO layer by an initiated chemical vapor deposition (iCVD) process.

In S530, the method for doping fluorine into an a-IGZO oxide channel of an oxide semiconductor memory device may deposit an aluminum oxide (Al₂O₃) layer on the polymer layer. In this case, the aluminum oxide (Al₂O₃) layer may act as a capping layer to prevent fluorine from being lost to the atmosphere during the subsequent heat treatment process. The aluminum oxide (Al₂O₃) layer may be deposited on the polymer layer by an atomic layer deposition (ALD) process.

In S540, the method for doping fluorine into an a-IGZO oxide channel of an oxide semiconductor memory device may perform a drive-in process so that fluorine contained in the perfluorodecanoic acid (PFDA) is doped into the a-IGZO layer. In this case, heat of 400° C may be applied so that fluorine may be doped into the a-IGZO layer.

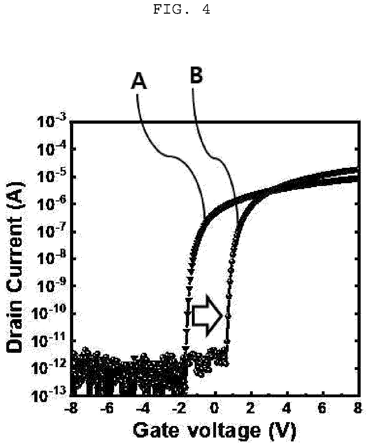

FIG. 4 is a graph illustrating the effect of the oxide semiconductor memory device according to an exemplary embodiment of the present disclosure.

FIG. 4 is a graph comparing threshold voltages of gate voltages according to drain current values of the oxide semiconductor memory device according to an exemplary embodiment of the present disclosure and the conventional oxide semiconductor memory device.

The conventional oxide semiconductor memory device is a semiconductor memory device of an oxide channel formed of only a-IGZO, and a gate voltage according to a drain current may appear as A. On the other hand, an oxide semiconductor memory device according to an exemplary embodiment of the present disclosure is a semiconductor memory device of an oxide channel formed of the fluorine doped a-IGZO, and the gate voltage according to the drain current may appear as B.

It can be confirmed that a semiconductor memory device A of the oxide channel formed of only the a-IGZO shows a threshold voltage of a negative value (-1.3 V), while a semiconductor memory device B of the fluorine doped a-IGZO oxide channel of the present disclosure shows a threshold voltage of a positive value (0.9 V). When the threshold voltage shows the negative value, there is a problem of having a normally-on characteristic, but when the fluorine doped a-IGZO oxide is used, it may have a normally-off characteristic.

In addition, it can be confirmed that the semiconductor memory device B including the fluorine doped a-IGZO oxide channel according to the present disclosure also has an increased on-current performance.

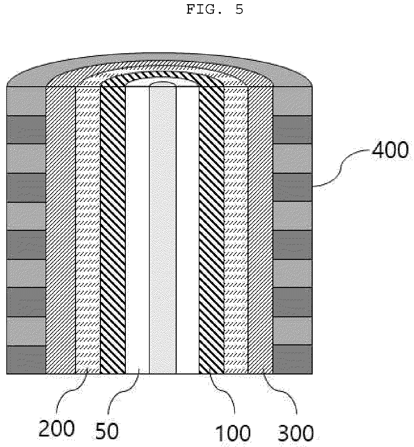

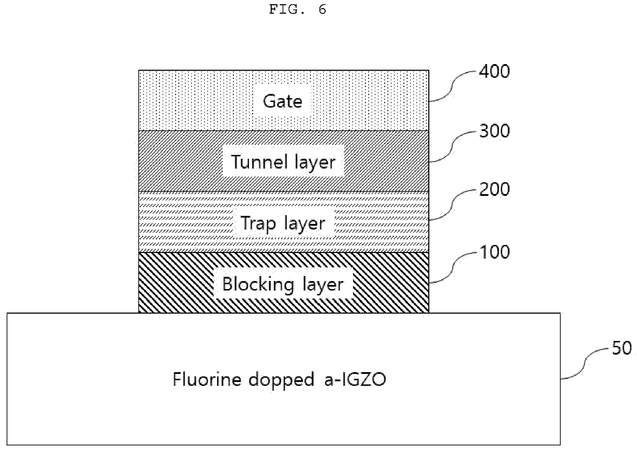

FIG. 5 is a cross-sectional view illustrating a configuration of the oxide semiconductor memory device according to an exemplary embodiment of the present disclosure, and FIG. 6 is a configuration diagram illustrating the configuration of the oxide semiconductor memory device according to an exemplary embodiment of the present disclosure.

Referring to FIGS. 5 and 6, the oxide semiconductor memory device according to an exemplary embodiment of the present disclosure may include a blocking layer 100 that is located on an oxide channel 50, a charge trap layer 300 that is located on the blocking layer 100 and traps an injected charge, a tunnel layer 300 that is located on the charge trap layer 200, a gate electrode 400 that is located on the tunnel layer 300 and applied with an on voltage and an off voltage from a gate bias circuit, and the oxide channel 50.

Here, the oxide channel 50 may be formed of the fluorine doped a-IGZO. In addition, the polymer layer containing the perfluorodecanoic acid (PFDA) may be deposited on the oxide channel 50 by the initiated chemical vapor deposition (iCVD) process to dope fluorine into the a-IGZO. In addition, the aluminum oxide (Al₂O₃) layer may be deposited on the oxide channel 50 by the atomic layer deposition (ALD) thin film process to prevent fluorine from being lost to the atmosphere when performing a heat treatment process to dope fluorine into the a-IGZO.

According to the present disclosure, it is possible to improve the threshold voltage and mobility performance by doping the oxide channel formed of the a-IGZO with fluorine.

In addition, according to the present disclosure, it is possible to uniformly dope fluorine into the a-IGZO oxide channel using the iCVD process.

In addition, according to the present disclosure, it is possible to reduce the oxygen vacancy value and efficiently passivate the bulk traps.

Although exemplary embodiments of the present disclosure have been described above, the embodiments disclosed in the present disclosure are only for explaining, not limiting, the technical spirit of the present disclosure. Therefore, the technical idea of the present disclosure includes not only each disclosed embodiment but also a combination of the disclosed embodiments, and furthermore, the scope of the technical idea of the present disclosure is not limited by these embodiments. In addition, many modifications and alterations of the present disclosure may be made by those skilled in the art to which the present disclosure pertains without departing from the spirit and scope of the accompanying claims. In addition, it is to be considered that all of these modifications and alterations fall within the scope of the present disclosure.

## Claims

1. A method for manufacturing an oxide semiconductor memory device, comprising:
(a) alternately laminating a word line and an inter layer dielectric;
(b) forming a cylindrical hole in a center of the laminated word line and the inter layer dielectric and forming a tunnel layer on an inner circumferential surface of the hole;
(c) forming a charge trap layer on an inner circumferential surface of the tunnel layer;
(d) forming a blocking layer on an inner circumferential surface of the charge trap layer;
(e) forming an oxide channel on an inner circumferential surface of the blocking layer; and
(f) forming a gate electrode by removing the inter layer dielectric and depositing a metal along the word line,
wherein, in (e), the oxide channel is formed of amorphous indium-gallium-zinc-oxide (a-IGZO) doped with fluorine.

2. The method of claim 1, wherein (e) includes:
(e-1) depositing an a-IGZO layer;
(e-2) depositing a polymer layer containing a perfluorodecanoic acid (PFDA) on the a-IGZO layer;
(e-3) depositing an aluminum oxide (Al₂O₃) layer on the polymer layer; and
(e-4) performing a drive-in process of applying heat to the oxide channel.

3. The method of claim 2, wherein in (e-2), the polymer layer containing the perfluorodecanoic acid is deposited by an initiated chemical vapor deposition (iCVD) process.

4. The method of claim 2, wherein in (e-3), the aluminum oxide layer is deposited by an atomic layer deposition (ALD) process.

5. The method of claim 2, wherein in (e-4), heat of 400°C is applied.

6. An oxide semiconductor memory device, comprising:
a blocking layer that is located on an oxide channel;
a charge trap layer that is located on the blocking layer and traps an injected charge;
a tunnel layer that is located on the charge trap layer; and
a gate electrode that is located on the tunnel layer and applied with an on voltage and an off voltage from a gate bias circuit,
wherein the oxide channel is formed of fluorine doped amorphous indium-gallium-zinc-oxide (a-IGZO).

7. The oxide semiconductor memory device of claim 6, wherein the oxide channel deposits a polymer layer containing a perfluorodecanoic acid (PFDA) by an initiated chemical vapor deposition (iCVD) process.

8. The oxide semiconductor memory device of claim 6, wherein the oxide channel deposits an aluminum oxide (Al₂O₃) layer by an atomic layer deposition (ALD) process.
